# EUROPEAN PATENT SPECIFICATION

(11) **EP 4 184 488 B1**
(45) Date of publication and mention of the grant of the patent: **07.05.2025**
(21) Application number: 22208204.2
(22) Date of filing: 18.11.2022
(51) Int. Cl.: G09F 9/302, G09F 9/37, G09F 9/33, G09F 19/00, G09F 7/20, G09F 15/00

(54) **LED DISPLAY DEVICE**
LED-ANZEIGEVORRICHTUNG
DISPOSITIF D'AFFICHAGE À DEL

(30) Priority: 19.11.2021 CN 202111400095
(43) Date of publication of application: 24.05.2023
(73) Proprietor: Shenzhen Leyard Opto-Electronic Co., Ltd., Shenzhen Guangdong 518110 (CN)
(72) Inventor: WANG, Liyong, Shenzhen, Guangdong, 518110 (CN); HUANG, Xuexiang, Shenzhen, Guangdong, 518110 (CN); ZHENG, Jinlong, Shenzhen, Guangdong, 518110 (CN)
(74) Representative: Berggren Oy

(56) References cited:
- CN-A- 110 379 325
- JP-A- 2013 178 293
- US-A1- 2012 228 241

## Description

### Technical Field

The disclosure relates to a technical field of light-emitting diode (LED) display, in particular to an LED display device.

### Background

Light-emitting diode (LED) display devices are electronic display screens composed of LED dot matrices. The forms of display contents on the screen, for example, texts, animations, pictures and videos are timely switched by turning on and off red and green lamp beads, and the display control of assemblies is implemented by means of modular structures. The LED display device includes an LED display screen, a control system and a power source system. The LED display screens are composed of LED dot matrices to emit light. The control system switches the display contents on the screens by adjusting and controlling the on/off state of areas. The power source system is used to convert input voltages and currents to satisfy the requirements of the display screen. The LED display screen can switch different forms of various information presentation modes, and can be used indoors and outdoors, with incomparable advantages over other display screens. Featuring high brightness intensity, low power consumption, low voltage requirement, small size, convenient use, long service life, stable impact resistance, and strong resistance to external interference, the LED display screen develops rapidly and has been widely applied in various fields.

The LED display devices in the related art are all formed by splicing LED display screens. Since stress deformation will be resulted from the gravity and long-term use, the gravity of the upper-layer LED display screens acts on the lower-layer LED display screens to press the lower-layer LED display screens. In this case, when the lower-layer LED display screens are required to be repaired and replaced, it will be difficult to take out the lower-layer LED display screens under pressure from the gravity.

In the prior art, when the LED display screens are in the front-maintained mode, if a certain lower-layer LED display screen is required to be repaired and replaced, all the upper-layer LED display screens above the LED display screen are required to be detached, resulting in difficult repair.

Examples of a stand apparatus according to the prior art are known from US20120228241A1. And examples of a Rapid splicing display method for LED screens with different dot spacings and different dot matrixes according to the prior art are known from CN110379325A. And a Knockdown screen according to the prior art is known from JP2013178293A.

### Summary

The main objective of the disclosure is to provide a light-emitting diode (LED) display device, so as to solve the problem that in the prior art, when a certain LED display screen at a lower layer is required to be repaired and replaced, all upper-layer LED display screens above the LED display screen are required to be detached, resulting in difficult repair.

The invention is as defined in claim 1.

In order to realize the above objective, the disclosure provides an LED display device. The LED display device includes: a support; a plurality of display assemblies mounted on a front side of the support, wherein the plurality of display assemblies are arranged in an array on the support, each display assembly is slidably arranged in an upper-lower direction, and each display assembly includes a frame and an LED display screen detachably arranged on a front side of the frame; and a plurality of gas bags, wherein each gas bag is arranged between the frames of two display assemblies adjacent to each other in the upper-lower direction, each gas bag has an expanded state and a flat state, when the gas bag is in the flat state, two adjacent display assemblies located above and below the gas bag cooperate with each other in a contact manner, and when the gas bag is switched from the flat state to the expanded state, the frame above the gas bag may be driven to slide upwards, such that a detachment gap is formed between the two adjacent display assemblies located above and below the gas bag.

In some embodiments, each gas bag includes a flat gas bag body and a gas nozzle arranged on the gas bag body, first accommodation recesses for accommodating the gas bag body are provided on the frames of the two adjacent display assemblies located above and below, and the gas nozzle passes through the frames.

In some embodiments, the LED display device further includes a gas source device for supplying gas to the plurality of gas bags, the gas source device includes a gas pump and/or an inflator, the gas source device further includes a plurality of first gas channels in communication with the gas pump and/or the inflator, the plurality of first gas channels are connected in parallel, the plurality of first gas channels are in communication with the plurality of gas bags in a one-to-one correspondence manner, and a first gate valve is arranged on each of the first gas channels.

In some embodiments, the gas source device further includes an overflow gas channel in communication with any one of the first gas channels, and an overflow valve is arranged on the overflow gas channel.

In some embodiments, the gas source device includes the gas pump and the inflator, the gas pump and the inflator are connected in parallel, the plurality of first gas channels converge at a junction, the junction is in communication with the gas pump by a second gas channel, a first one-way valve is arranged on the second gas channel, a third gas channel is arranged between an inlet of the first one-way valve and the inflator, a second one-way valve is arranged on the third gas channel, a fourth gas channel is arranged between the junction and an outlet of the first one-way valve, and a second gate valve is arranged on the fourth gas channel.

In some embodiments, the LED display device further includes a plurality of vertical rods arranged at intervals and a plurality of horizontal rods arranged at intervals, the vertical rods and the horizontal rods are arranged in a staggered manner, every two adjacent vertical rods pass through one frame, every two adjacent horizontal rods pass through one frame, and a movement gap in the upper-lower direction is formed between a through hole of each frame allowing the horizontal rods to pass through and a corresponding horizontal rods.

In some embodiments, a chute is provided on one frame of two adjacent frames located left and right, and a slide block matching the chute in an inserted manner is arranged on the other frame.

In some embodiments, a second accommodation recess for accommodating a ball is provided on a back side of each frame, and a portion of the ball protruding out of an opening of the second accommodation recess cooperates with a surface of the support in a contact manner.

In some embodiments, a pair of limiting members located on an upper side and a lower side of the ball is arranged on the frame, and the limiting members are detachably located in the second accommodation recess.

In some embodiments, the LED display device further includes a plurality of fasteners penetrating through the support, one corresponding frame is adjustably mounted on the support by each fastener, an avoiding hole allowing the fasteners to pass through are provided on the support, an aperture of the avoiding hole is greater than an outer diameter of each fastener, connecting holes tightly connected to the fasteners are provided on the frames, the LED display device further includes a plurality of damping members, the plurality of damping members and the plurality of fasteners are arranged in a one-to-one correspondence manner, and the damping members are located between the avoiding holes and heads of the fasteners, such that the fasteners may swing up and down in the avoiding holes when the frames slide up and down.

In some embodiments, the fasteners include screw heads and screw rods connected with the screw heads, the connecting holes are screw holes connected with the screw rods, the avoiding holes include elongated hole sections for avoiding the screw rods, and reamed hole sections for accommodating the screw heads, each reamed hole section has an aperture greater than a maximum value of apertures of the elongated hole sections, step surfaces are formed between the reamed hole sections and the elongated hole sections, the damping members include springs sleeving the screw rods, and the springs are located between the screw heads and the step surfaces.

By employing the technical solution of the disclosure, the LED display device includes: a support, a plurality of display assemblies and a plurality of gas bags. The plurality of display assemblies are mounted on a front side of the support. The plurality of display assemblies are arranged in an array on the support. Each display assembly is slidably arranged in an upper-lower direction. Each display assembly includes a frame and an LED display screen detachably arranged on a front side of the frame. Each gas bag is arranged between the frames of two display assemblies adjacent to each other in the upper-lower direction, and each gas bag has an expanded state and a flat state. In the disclosure, when the gas bag is in the flat state, two adjacent display assemblies located above and below the gas bag cooperate with each other in a contact manner. When a lower LED display screen is required to be replaced, the gas bag above the LED display screen required to be repaired is switched from the flat state to the expanded state, and the frame above the gas bag may be driven to slide upwards, such that a detachment gap is formed between the two adjacent display assemblies located above and below the gas bag. In this way, the LED display screen above the lower LED display screen required to be repaired is slightly lifted, such that the LED display screen required to be maintained is not pressed by the upper LED display screen, the lower LED display screen required to be maintained may be easily taken down from the corresponding frame and taken out from the plurality of display assemblies. Therefore, the LED display screen required to be maintained is easy to repair. Furthermore, in the situation that a plurality of LED display screens are arranged above an LED display screen required to be maintained, the lower LED display screen to be maintained may be easily replaced and repaired, and front maintenance is convenient. Therefore, the technical solution of the disclosure may solve the problem that in the prior art, when a certain LED display screen at a lower layer is required to be repaired and replaced, all upper-layer LED display screens above the LED display screen are required to be detached, resulting in difficult repair.

### Brief Description of the Drawings

The accompanying drawings of the description, which constitutes a part of the disclosure, are used to provide further understanding of the disclosure, and illustrative embodiments of the disclosure and the description thereof are used to explain the disclosure, which are not intended to unduly limit the disclosure. In the accompanying drawings:
Fig. 1 shows a solid schematic structural diagram of an embodiment of a light-emitting diode (LED) display device according to the disclosure;
Fig. 2 shows a solid schematic structural diagram in the situation that an upper LED display assembly of the LED display device in Fig. 1 is lifted by a gas bag;
Fig. 3 shows a solid schematic structural diagram in the situation that a lower LED display screen of the LED display device in Fig. 1 is taken out;
Fig. 4 shows a solid schematic structural diagram from another angle of the LED display device in Fig. 1;
Fig. 5 shows a schematic diagram of a gas source device of the LED display device in Fig. 1;
Fig. 6 shows a solid schematic structural diagram of a front side of a mounting box of the LED display device in Fig. 1;
Fig. 7 shows a solid schematic structural diagram of a back side of a mounting box of the LED display device in Fig. 1;
Fig. 8 shows an exploded schematic structural diagram of the LED display device in Fig. 1;
Fig. 9 shows an enlarged schematic diagram of a position A of the LED display device in Fig. 8;
Fig. 10 shows a solid schematic structural diagram in the situation that the LED display device in Fig. 4 is partially cut;
Fig. 11 shows an enlarged schematic diagram of a position B of the LED display device in Fig. 10;
Fig. 12 shows an enlarged schematic diagram of a position C of the LED display device in Fig. 10;
Fig. 13 shows an enlarged schematic diagram of a position D of the LED display device in Fig. 11;
Fig. 14 shows a solid schematic structural diagram of fasteners and damping members of the LED display device in Fig. 1;
Fig. 15 shows a solid schematic structural diagram of a gas bag of the LED display device in Fig. 1;
Fig. 16 shows a schematic front view of the LED display device in Fig. 1 with a plurality of LED display screens detached; and
Fig. 17 shows a solid schematic structural diagram of a frame of the LED display device in Fig. 1.

The above accompanying drawings include the following reference numerals:
10: support; 11: avoiding hole; 111: elongated hole section; 112: reamed hole section; 20: display assembly; 21: frame; 211: first accommodation recess; 212: second accommodation recess; 213: connecting hole; 22: LED display screen; 30: gas bag; 31: gas bag body; 32: gas nozzle; 40: gas source device; 41: gas pump; 42: inflator; 431: first gas channel; 432: second gas channel; 433: third gas channel; 434: fourth gas channel; 44: first gate valve; 45: overflow valve; 46: first one-way valve; 47: second one-way valve; 48: second gate valve; 51: vertical rod; 52: horizontal rod; 61: chute; 62: slide block; 63: ball; 64: limiting member; 71: fastener; 711: screw head; 712: screw rod; 72: damping member; 73: washer; 80: mounting box; 81: gas inlet; 82: gas outlet; 83: inflating port; and 84: gas pump switch.

### Detailed Description of the Embodiments

The technical solutions of the embodiments of the disclosure will be clearly and completely described below in combination with the accompanying drawings in the embodiments of the disclosure. Apparently, the described embodiments are merely part rather than all of the embodiments of the disclosure. The following description of at least one illustrative embodiment is merely illustrative in nature and in no way serves as any limitation of the disclosure and application or uses thereof. On the basis of the embodiments of the disclosure, all other embodiments obtained by those of ordinary skill in the art without making inventive efforts all fall within the protection scope of the disclosure.

It should be noted that the terms used herein are merely for describing the specific implementations and are not intended to limit the illustrative implementations according to the disclosure. As used herein, a singular form is intended to include a plural form as well, unless the context clearly dictates otherwise, and in addition, it should be understood that the terms "contain" and/or "include", when used in the description, specify the presence of features, steps, operations, devices, assemblies, and/or combinations thereof.

Unless specifically stated otherwise, relative arrangements, numerical expressions and values of the assemblies and steps stated in these embodiments do not limit the scope of the disclosure. Moreover, it should be understood that the sizes of the various parts shown in the accompanying drawings are not drawn according to an actual scale for ease of description. Technique, methods and devices known to those of ordinary skill in the related art may not be discussed in detail, but should be considered as a part of the authorized description where appropriate. In all examples shown and discussed herein, any specific value should be interpreted as merely illustrative and not as limiting. Thus, other examples of the illustrative embodiments can have different values. It should be noted that similar numerals and letters denote similar items in the following accompanying drawings, and therefore, once a certain item is defined in one figure, it is not required to be further discussed in the subsequent figures.

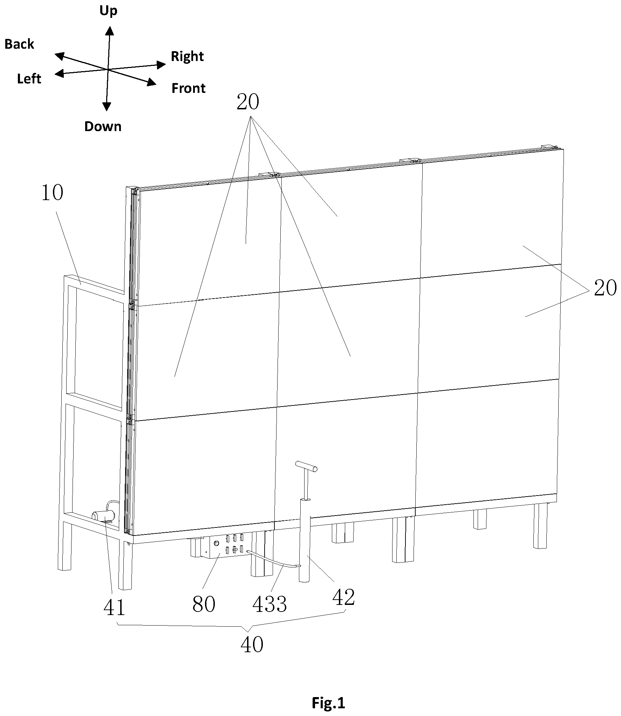

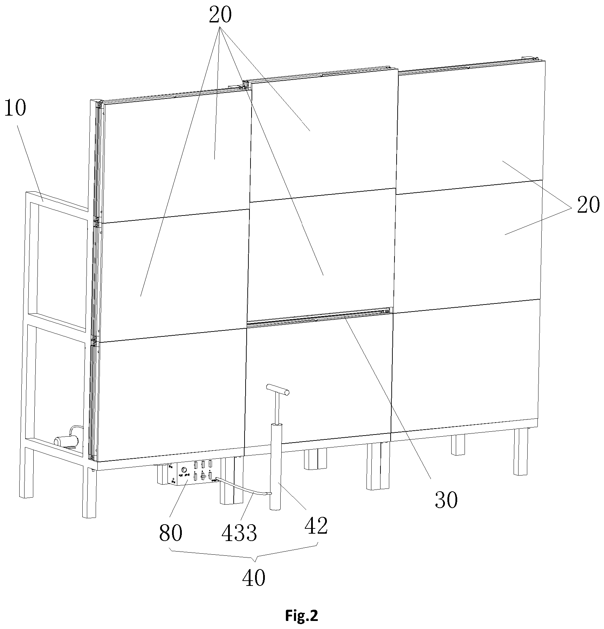

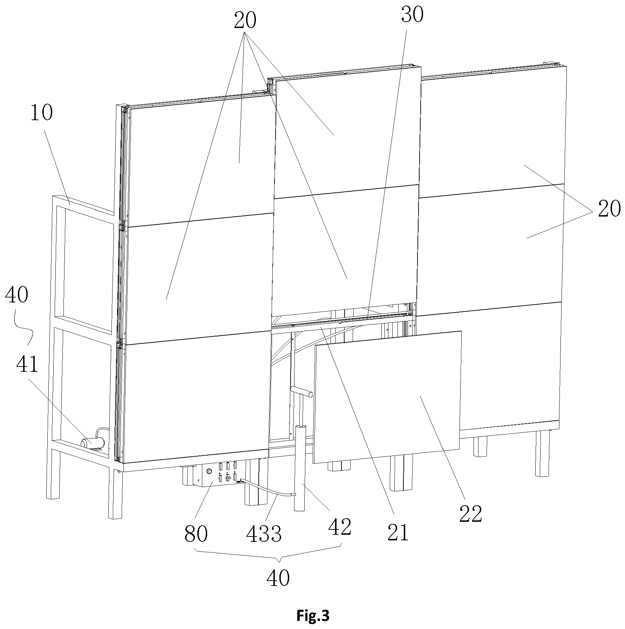

As shown in Figs. 1-5, a light-emitting diode (LED) display device in the embodiment includes: a support 10, a plurality of display assemblies 20 and a plurality of gas bags 30. The plurality of display assemblies 20 are mounted on a front side of the support 10. The plurality of display assemblies 20 are arranged in an array on the support 10. Each display assembly 20 is slidably arranged in an upper-lower direction. Each display assembly 20 includes a frame 21 and an LED display screen 22 detachably arranged on a front side of the frame 21. Each gas bag 30 is arranged between the frames 21 of two display assemblies 20 adjacent to each other in the upper-lower direction, and each gas 30 bag has an expanded state and a flat state. In the embodiment, when the gas bag 30 is in the flat state, two adjacent display assemblies 20 located above and below the gas bag 30 cooperate with each other in a contact manner, and when the gas bag 30 is switched from the flat state to the expanded state, the frame 21 above the gas bag 30 may be driven to slide upwards, such that a detachment gap is formed between the two adjacent display assemblies 20 located above and below the gas bag 30.

By applying the technical solution of the embodiment, when the gas bag 30 is in the flat state, the two adjacent display assemblies 20 located above and below the gas bag 30 cooperate with each other in a contact manner. When a lower LED display screen 22 is required to be replaced, the gas bag 30 above the LED display screen 22 required to be repaired is switched from the flat state to the expanded state, and the frame 21 above the gas bag 30 may be driven to slide upwards, such that a detachment gap is formed between the two adjacent display assemblies 20 located above and below the gas bag 30. In this way, the LED display screen 22 above the lower LED display screen 22 required to be repaired is slightly lifted, such that the LED display screen 22 required to be maintained is not pressed by the upper LED display screen, the lower LED display screen 22 required to be maintained may be easily taken down from the corresponding frame 21 and taken out from the plurality of display assemblies 20. Therefore, the LED display screen 22 required to be maintained is easy to repair. Further, in the situation that a plurality of LED display screens 22 are arranged above an LED display screen 22 required to be maintained, the lower LED display screen 22 required to be maintained may be easily replaced and repaired, an enough repair space for operation of engineering personnel is not required to be reserved at a back portion of the LED display device, and front maintenance is convenient. Moreover, repair cost may be reduced, repair efficiency may be improved, and the purpose of independently repairing a broken LED display screen 22 may be realized. Therefore, the technical solution of the embodiment may solve the problem that in the prior art, when a certain LED display screen at a lower layer is required to be repaired and replaced, all upper-layer LED display screens above the LED display screen are required to be detached, resulting in difficult repair.

It should be noted that the above expanded state corresponds to a state of the gas bag 30 that is inflated, and the above flat state corresponds to a state of the gas bag 30 that is deflated or gasless.

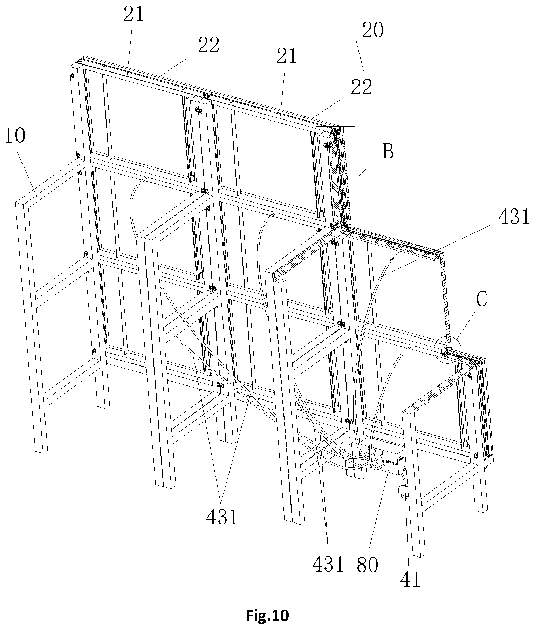

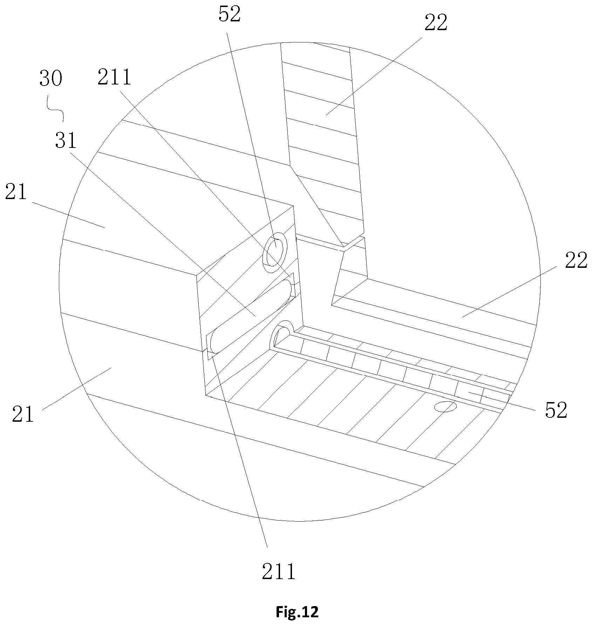

As shown in Figs. 10, 12 and 15, each gas bag 30 includes a flat gas bag body 31 and a gas nozzle 32 arranged on the gas bag body 31. When the gas bag 30 is in the expanded state, the flat gas bag body 31 is attached to an upper surface and a lower surface of corresponding adjacent frames 21 located above and below, such that the gas bag 30 may stably lift the upper frame 21 and prevent the frame 21 from falling. Moreover, compared with a spherical or elliptical gas bag, the flat gas bag body 31 is narrower and longer, and occupies less space. When the gas bag 30 is in the flat state, in order to prevent the frames 21 of the two adjacent display assemblies 20 located above and below from pressing the gas bag 30 to damage the gas bag 30, first accommodation recesses 211 for accommodating the gas bag body 31 are provided on the frames 21 of the two adjacent display assemblies 20 located above and below, and the gas nozzle 32 passes through the frames 21.

As shown in Figs. 1-5, the LED display device further includes a gas source device 40 for supplying gas to the plurality of gas bags 30. The gas source device 40 includes a gas pump 41 and an inflator 42, the gas source device 40 further includes a plurality of first gas channels 431 in communication with the gas pump 41 and the inflator 42, the plurality of first gas channels 431 are connected in parallel, the plurality of first gas channels 431 are in communication with the plurality of gas bags 30 in a one-to-one correspondence manner, and a first gate valve 44 is arranged on each of the first gas channels 431. The gas pump 41 inflates the plurality of gas bags 30 by the plurality of first gas channels 431, the plurality of gas bags and the plurality of first gas channels being arranged in a one-to-one correspondence manner. Each first gate valve 44 may connect or disconnect a corresponding first gas channel 431. For a lower LED display screen 22 required to be maintained, the gas bag 30 above the frame 21 corresponding to the LED display screen 22 is required to be inflated, and at this time, all the other first gate valves 44 may be closed, and only the first gate valve 44 of the gas bag 30 corresponding to the LED display screen 22 required to be maintained is opened. If there is no power source for supplying power to the gas pump 41 due to environmental restrictions, inflation may be manually carried out by the inflator 42 without affecting repair. The first gate valve 44 may be a manual valve or an electric valve. The first gate valve 44 is preferably a ball valve. The gas source device 40 in the embodiment uses air as a conductive medium, which is environment-friendly and pollution-free. The LED display device in the embodiment uses pneumatic transmission, which effectively reduces the number of mechanisms and parts for mechanical transmission, and may reduce cost.

Certainly, in embodiments not shown in the figures, the gas source device may only include a gas pump, and the gas source device further include a plurality of first gas channels in communication with the gas pump. The gas source device may only include an inflator, and the gas source device further include a plurality of first gas channels in communication with the inflator.

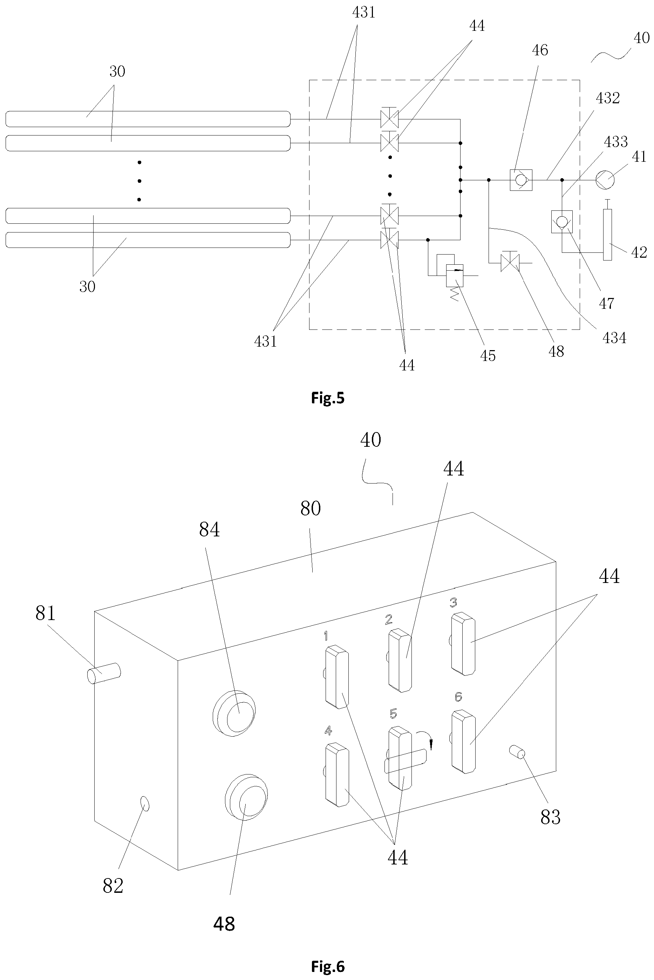

As shown in Fig. 5, the gas source device 40 further includes an overflow gas channel in communication with any one of the first gas channels 431, and an overflow valve 45 is arranged on the overflow gas channel. Through the arrangement of the overflow valve 45, a preset constant gas pressure is provided to the gas source device 40, so as to guarantee that the pressure is in a safe range, and guarantee safety of the gas pump, each first gas channel 431 and each gas bag 30.

As shown in Fig. 5, the gas source device 40 includes a gas pump 41 and an inflator 42. The gas pump 41 and the inflator 42 are connected in parallel, the plurality of first gas channels 431 converge at a junction, the junction is in communication with the gas pump 41 by a second gas channel 432, and a first one-way valve 46 is arranged on the second gas channel 432. Through the arrangement of the first one-way valve 46, gas in the second gas channel 432 is prevented from flowing back. A third gas channel 433 is arranged between an inlet of the first one-way valve 46 and the inflator 42, and a second one-way valve 47 is arranged on the third gas channel 433. Through the arrangement of the second one-way valve 47, gas in the third gas channel 433 is prevented from flowing back. A fourth gas channel 434 is arranged between the junction and an outlet of the first one-way valve 46, and a second gate valve 48 is arranged on the fourth gas channel 434. Through the arrangement of the second gate valve 48, gas in the second gas channel 432 and the first gas channel 431 may be conveniently discharged after the LED display device is front-maintained. The second gate valve 48 may be a manual valve or an electric valve. The second gate valve 48 is preferably a ball valve.

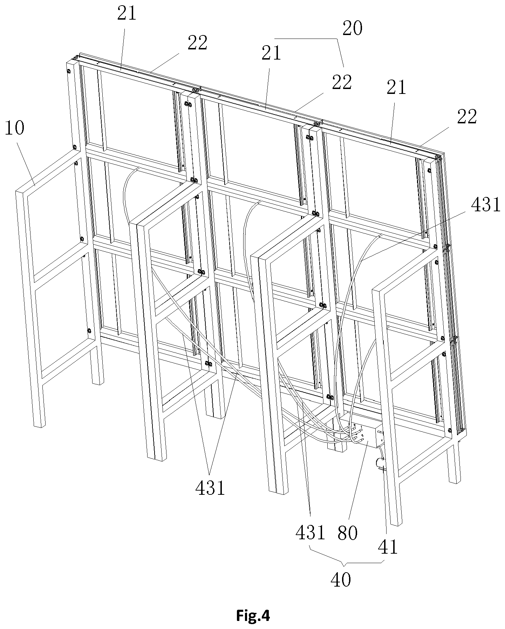

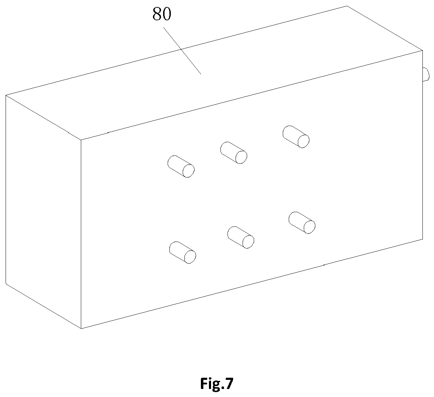

As shown in Figs. 4-7, the gas source device 40 in the embodiment further includes a mounting box 80 located below the support 10, the above overflow gas channel, overflow valve 45, second gas channel 432, first one-way valve 46, fourth gas channel 434, and second one-way valve 47 are all mounted in the mounting box 80. A gas inlet 81, a gas outlet 82, an inflating port 83 and a gas pump switch 84 are provided on the mounting box 80 at intervals. The second gas channel 432 is in communication with the gas inlet 81, the fourth gas channel 434 is in communication with the gas outlet 82, and the third gas channel 433 is in communication with the inflating port 83. The gas pump 41 is located outside the mounting box 80, and the gas pump 41 is connected to the gas pump switch 84. Through the arrangement of the mounting box 80, the gas source device 40 is more compact in structure, and convenient to carry and operate. The second gate valve 48 and the plurality of first gate valves 44 are mounted on the mounting box 80 at intervals, the second gate valve 48 is normally in a closed state, and the plurality of first gate valves 44 are normally in a closed state.

It should be noted that three "▪" between two first gate valves 44 in Fig. 5 are ellipses, indicating that several first gate valves 44 are omitted. Three "▪" between two gas bags 30 in Fig. 5 are ellipses, indicating that several gas bags 30 are omitted.

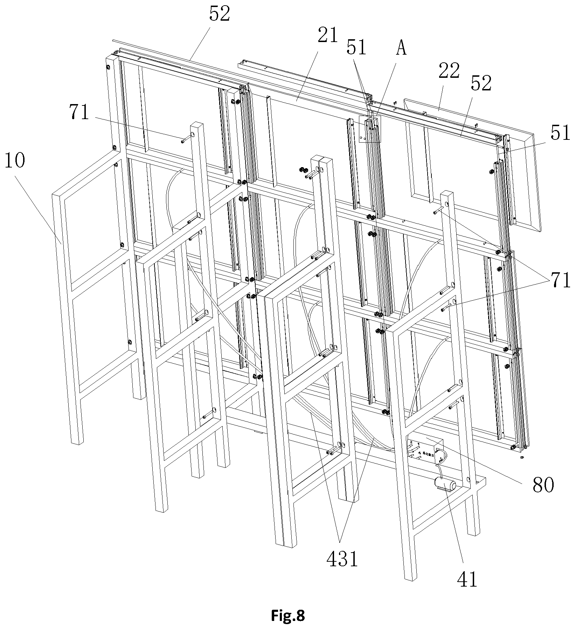

As shown in Figs. 8-11, the LED display device further includes a plurality of vertical rods 51 arranged at intervals and a plurality of horizontal rods 52 arranged at intervals. The vertical rods 51 and the horizontal rods 52 are arranged in a staggered manner, there is a distance between the vertical rods 51 and the horizontal rods 52 in a front-back direction of support 10, every two adjacent vertical rods 51 pass through one frame 21, and every two adjacent horizontal rods 52 pass through one frame 21. In this way, a plurality of display assemblies 20 are assembled together by the plurality of vertical rods 51 and the plurality of horizontal rods 52 that are arranged in a staggered manner. A movement gap in the upper-lower direction is provided between through holes of each frame 21 allowing the horizontal rods 52 to pass through and the corresponding horizontal rods 52. Each vertical rod 51 pass through a plurality of display assemblies 20 arranged in a row in an up-down direction of support 10, and each horizontal rod 52 pass through a plurality of display assemblies 20 arranged in a row in a left-right direction of support 10. Each through hole of each frame 21 allowing the horizontal rod 52 to pass through may be a round hole or an elliptical hole having an aperture greater than an outer diameter of the horizontal rod 52, or may be an elongated hole having a minimum aperture greater than an outer diameter of the horizontal rod 52. The above movement gap has a diameter of 1 mm - 3 mm.

As shown in Figs. 8-11, first external threads are provided on portions of two ends of each vertical rod 51 protruding out of an upper surface and a lower surface of each of the plurality of LED display assemblies respectively, and the LED display device further includes first nuts connected to the first external threads. Second external threads are provided on portions of two ends of each horizontal rod 52 protruding out of a left surface and a right surface of each of the plurality of LED display assemblies respectively, and the LED display device further includes second nuts connected to the second external threads. When a lower LED display screen 22 is required to be repaired and replaced, the first nuts on the vertical rods 51 on two sides of a row where the LED display screen 22 required to be repaired is located is required to be unscrewed first, such that each frame 21 of the row where the LED display screen 22 required to be repaired is located may be loosened, and when the gas bag 30 above the LED display screen 22 required to be repaired is switched from the flat state to the expanded state, the frame 21 above the gas bag 30 may be driven to slide upwards.

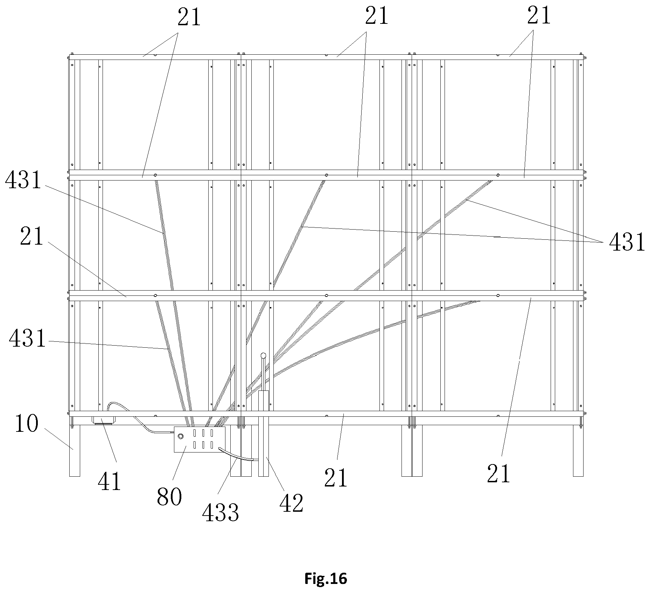

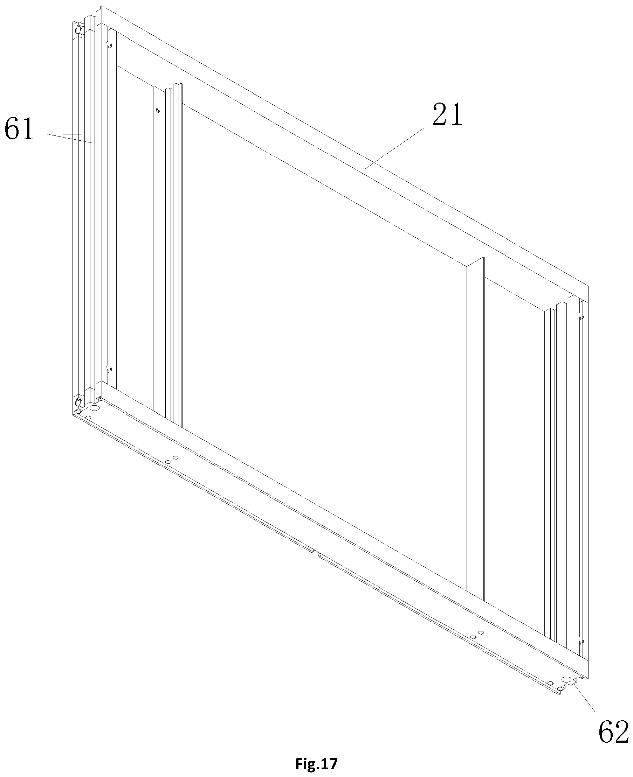

As shown in Figs. 8, 9, 16 and 17, a chute 61 is provided on one frame 21 of two adjacent frames 21 located left and right, and a slide block 62 matching the chute 61 in an inserted manner is arranged on the other frame 21 of two adjacent frames 21. In this way, through matching between the chute 61 and the slide block 62, one frame 21 of two adjacent frames 21 located left and right may slide upwards relative to the other frame 21. Preferably, one chute 61 and one slide block 62 are arranged on a left side and a right side of one frame 21 for the convenience of processing and forming. In this way, the LED display device is simple in structure, and easy to mount and operate.

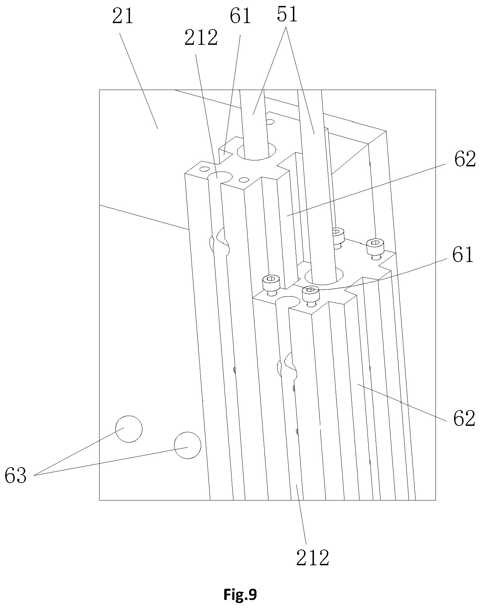

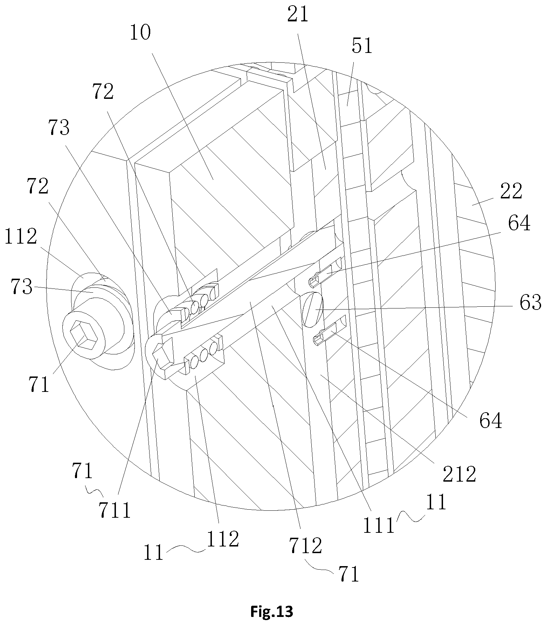

As shown in Figs. 9 and 13, a second accommodation recess 212 for accommodating a ball 63 is provided on a back side of each frame 21, and a portion of each ball 63 protruding out of an opening of the second accommodation recess 212 matches a surface of the support 10 in a contact manner. Since contact between the ball 63 and the surface of the support 10 is point-to-surface contact, a friction coefficient is small. When a gas bag 30 above a LED display screen 22 required to be repaired is switched from the flat state to the expanded state, only a small support force is required to be provided by the gas bag 30 to lift the frame 21 above the gas bag 30, such that all the frames 21 above the gas bag 30 may slide upwards, which is easy and labor-saving. It should be noted that more than half of the ball 63 is located in the second accommodation recess 212, so as to prevent the ball 63 from being separated from the second accommodation recess 212 from a back side of the corresponding frame 21.

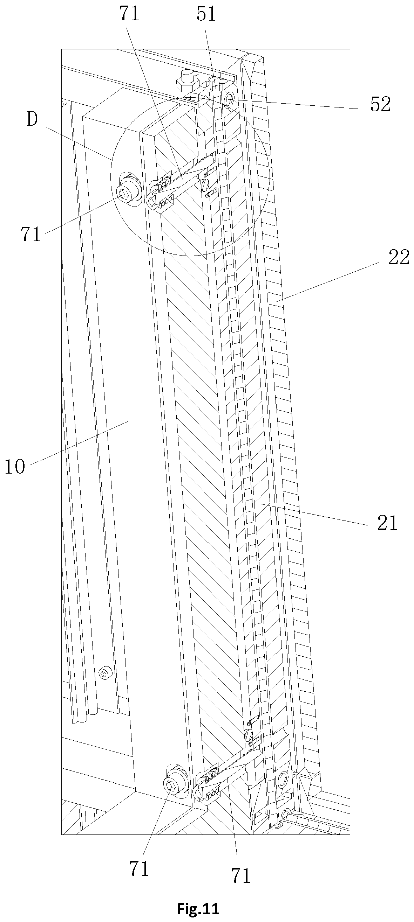

As shown in Figs. 11 and 13, a pair of limiting members 64 located on an upper side and a lower side of the ball 63 is arranged on each frame 21, and the limiting members 64 are detachably located in the second accommodation recess 212. The pair of limiting members 64 limit the upper side and the lower side of the ball 63 respectively, and the ball 63 is only allowed to roll in the second accommodation recess 212, such that when the frame 21 slides upwards or downwards, the ball 63 is prevented from moving upwards or downwards, and a working position of the ball 63 in the second accommodation recess 212 is prevented from changing. Specifically, there are two balls 63 arranged in the second accommodation recess 212 at an interval in the upper-lower direction on each frame 21. In this way, the frame 21 may stably slide upwards conveniently. The limiting members 64 in the embodiment are preferably bolts, and heads of the bolts are located in the second accommodation recesses 212, so as to prevent the situation that the heads of the bolts are in contact with the surface of the support 10, so as to interfere with the surface of the support.

Specifically, as shown in Figs. 9-12 and 17, each frame 21 includes a top beam and a bottom beam that may be oppositely spliced, and a first side beam and a second side beam that may be spliced between the top beam and the bottom beam, the top beam, the bottom beam, the first side beam and the second side beam defining a rectangular structure. The chutes 61 and the slide blocks 62 are arranged on the first side beams and the second side beams, and the chutes 61 on the first side beams are located outside the frames 21, and the slide blocks 62 on the second side beams are located outside the frames 21. Second accommodation recesses 212 are provided on the first side beams and the second side beams, and in order to conveniently mount the balls 63 in the second accommodation recesses 212, two ends of the second accommodation recess 212 on each first side beam extend to an upper surface and a lower surface of the first side beam respectively, and two ends of the second accommodation recess 212 on each second side beam extend to an upper surface and a lower surface of the second side beam respectively.

As shown in Figs. 10-14, the LED display device further includes a plurality of fasteners 71 penetrating the support 10. One corresponding frame 21 is adjustably mounted on the support 10 by each fastener 71. In order to create a movement space for the fastener 71 in an upper-lower direction, avoiding holes 11 allowing the fasteners 71 to pass through are provided on the support 10, and each avoiding hole 11 has an aperture greater than an outer diameter of each fastener 71. Through the provision of the avoiding holes 11, the fasteners 71 may slide up and down with the frames 21 when the frames 21 slide up and down. Connecting holes 213 tightly connected to the fasteners 71 are provided on the frames 21, and the LED display device further includes a plurality of damping members 72, the damping members 72 and the fasteners 71 are arranged in a one-to-one correspondence manner, and the damping members 72 are located between the avoiding holes 11 and heads of the fasteners 71, such that the fasteners 71 may swing up and down in the avoiding holes 11 when the frames 21 slide up and down. Through the arrangement of the damping members 72, the heads of the fasteners 71 may be conveniently pressed on the support 10, such that the fasteners 71 are tightly connected in the connecting holes 213, and the frames 21 are adjustably fixed on the support 10.

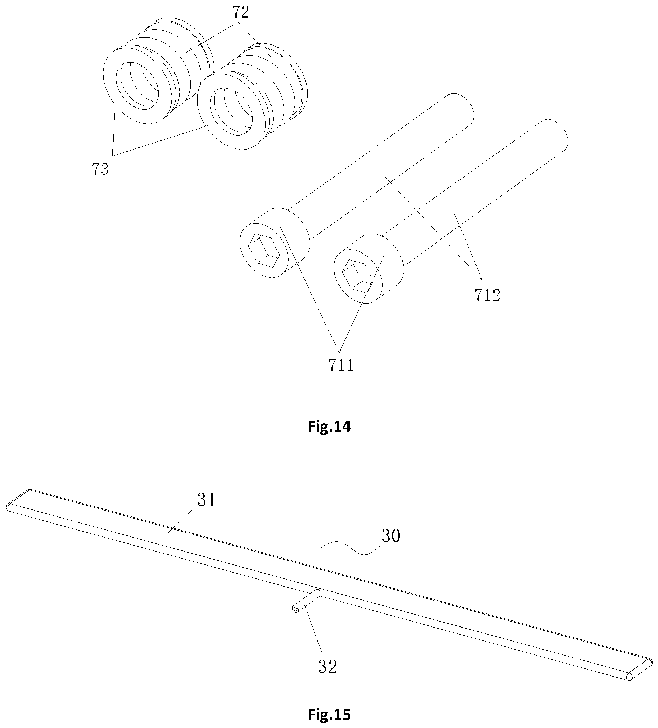

As shown in Figs. 13 and 14, the fasteners 71 include screw heads 711 and screw rods 712 connected to the screw heads 711. The connecting holes 213 are screw holes connected to the screw rods 712, the avoiding holes 11 include elongated hole sections 111 for avoiding the screw rods 712 and reamed hole sections 112 for accommodating the screw heads 711, and each reamed hole section 112 has an aperture greater than a maximum value of apertures of the elongated hole sections 111. Through the arrangement of the elongated hole sections 111, the avoiding holes 11 may conveniently avoid the screw rods 712, such that the screw rods 712 may swing up and down in the avoiding holes 11 when the frames 21 slide up and down. Step surfaces are formed between the reamed hole sections 112 and the elongated hole sections 111, the damping members 72 include springs sleeving the screw rods 712, and the springs are located between the screw heads 711 and the step surfaces. The screw heads 711 and the step surfaces limit the springs, such that the springs may always apply elastic forces to the fasteners 71. With the elastic forces of the springs, the gaps between the balls 63 and the support 10 may be eliminated, such that the balls 63 are tightly pressed on the surface of the support 10 in a front-back direction of the support 10. In this way, in the situation that the frames 21 are fixed on the support 10 by the fasteners 71, when the gas bag 30 above the LED display screen 22 required to be repaired is switched from the flat state to the expanded state, the gas bag 30 may also lift the frame 21 above the gas bag 30, such that all the frames 21 above the gas bag 30 may slide upwards.

As shown in Figs. 13 and 14, in the embodiment, the LED display device further includes washers 73 sleeving the fasteners 71, and the washers 73 are located between the screw heads 711 and the springs. In this way, through the arrangement of the washers 73, pressing forces applied to the springs by the fasteners 71 may be increased, such t-ZQShat adjustable fixation by the fasteners 71 is more reliable.

In the description of the disclosure, it should be understood that orientation or positional relations indicated by orientation words such as "front, back, upper, lower, left and right", "horizontal, vertical, perpendicular to and parallel with", and "top and bottom" are generally based on orientation or positional relations shown in the accompanying drawings, and are merely for the convenience of describing the disclosure and simplifying the description. Unless otherwise stated, these orientation words do not indicate or imply that devices or elements indicated thereby must have specific orientations or be constructed and operated in specific orientations, and therefore cannot be construed as limiting the protection scope of the disclosure. Orientation words "inside and outside" refer to an inside and an outside relative to an outline of each component.

For ease of description, spatial relative terms such as "on", "above", "on an upper surface" and "upper" can be used herein to describe spatial positional relations of one device or feature with other devices or features as shown in the figures. It should be understood that the spatial relative terms are intended to include different orientations in use or operation in addition to the orientations of the devices described in the figures. For example, if the device in the figures is inverted, the device described as "above" or "on" other devices or structures would then be positioned "below" or "under" the other devices or structures. Thus, the illustrative term "above" can include two orientations of "above" and "below." The device can also be positioned in other different ways (being rotated by 90 degrees or being positioned at other orientations), and the spatial relative description used herein is interpreted accordingly.

In addition, it should be noted that the use of the terms "first", "second", etc. to define parts is merely for convenience of distinguishing corresponding parts. Unless otherwise stated, the above words do not have special meanings, and therefore cannot be understood as limiting the protection scope of the disclosure.

## Claims

1. A light-emitting diode (LED) display device, comprising:
a support (10);
a plurality of display assemblies (20) mounted on a front side of the support (10), wherein the plurality of display assemblies (20) are arranged in an array on the support (10), each of the plurality of display assemblies (20) is slidably arranged in an upper-lower direction, and each of the plurality of display assemblies (20) comprises a frame (21) and an LED display screen (22) detachably arranged on a front side of the frame (21);
**characterized in that**, the LED display device further comprises a plurality of gas bags (30), wherein each of the plurality of gas bags (30) is arranged between the frames (21) of two display assemblies (20) adjacent to each other in the upper-lower direction, each of the plurality of gas bags (30) has an expanded state and a flat state,
when the gas bag (30) is in the flat state, two adjacent display assemblies (20) located above and below one of the plurality of gas bags (30) cooperate with each other in a contact manner, and when the one of the plurality of gas bags (30) is switched from the flat state to the expanded state, the frame (21) above the one of the plurality of gas bags (30) can be driven to slide upwards, such that a detachment gap is formed between the two adjacent display assemblies (20) located above and below the one of the plurality of gas bags (30).

2. The LED display device as claimed in claim 1, wherein each of the plurality of gas bags (30) comprises a flat gas bag body (31) and a gas nozzle (32) arranged on the gas bag body (31), first accommodation recesses (211) for accommodating the gas bag body (31) are provided on the frames (21) of the two adjacent display assemblies (20) located above and below, and the gas nozzle (32) passes through the frames (21) of the two adjacent display assemblies (20).

3. The LED display device as claimed in claim 1, further comprising a gas source device (40) for supplying gas to the plurality of gas bags (30), the gas source device (40) comprises a gas pump (41) and/or an inflator (42), the gas source device (40) further comprises a plurality of first gas channels (431) in communication with the gas pump (41) and/or the inflator (42), the plurality of first gas channels (431) are connected in parallel, the plurality of first gas channels (431) are in communication with the plurality of gas bags (30) in a one-to-one correspondence manner, and a first gate valve (44) is arranged on each of plurality of the first gas channels (431).

4. The LED display device as claimed in claim 3, wherein the gas source device (40) further comprises an overflow gas channel in communication with any one of plurality of the first gas channels (431), and an overflow valve (45) is arranged on the overflow gas channel.

5. The LED display device as claimed in claim 3, wherein the gas source device (40) comprises the gas pump (41) and the inflator (42), the gas pump (41) and the inflator (42) are connected in parallel, the plurality of first gas channels (431) converge at a junction, the junction is in communication with the gas pump (41) by a second gas channel (432), a first one-way valve (46) is arranged on the second gas channel (432), a third gas channel (433) is arranged between an inlet of the first one-way valve (46) and the inflator (42), a second one-way valve (47) is arranged on the third gas channel (433), a fourth gas channel (434) is arranged between the junction and an outlet of the first one-way valve (46), and a second gate valve (48) is arranged on the fourth gas channel (434).

6. The LED display device as claimed in claim 1, further comprising a plurality of vertical rods (51) arranged at intervals and a plurality of horizontal rods (52) arranged at intervals, each of plurality of the vertical rods (51) and each of plurality of the horizontal rods (52) are arranged in a staggered manner, every two adjacent vertical rods (51) of plurality of the vertical rods (51) pass through one frame (21), every two adjacent horizontal rods (52) pass through one frame (21), and a movement gap in the upper-lower direction is provided between a through hole of each frame (21) allowing the horizontal rods (52) to pass through and a corresponding horizontal rod (52) of plurality of horizontal rods (52).

7. The LED display device as claimed in claim 1, wherein a chute (61) is provided on a side of one frame (21) of two adjacent frames (21) located left and right, and a slide block (62) matching the chute (61) in an inserted manner is arranged on a side of the other frame (21) of two adjacent frames (21) located left and right.

8. The LED display device as claimed in claim 1, wherein a second accommodation recess (212) for accommodating a ball (63) is provided on a back side of each frame (21), and a portion of the ball (63) protruding out of an opening of the second accommodation recess (212) cooperates with a surface of the support (10) in a contact manner.

9. The LED display device as claimed in claim 8, wherein a pair of limiting members (64) located on an upper side and a lower side of the ball (63) is arranged on the frame (21), and the limiting members (64) are detachably located in the second accommodation recess (212).

10. The LED display device as claimed in claim 1, further comprising a plurality of fasteners (71) penetrating through the support (10), one corresponding frame (21) is adjustably mounted on the support (10) by each of the plurality of fasteners (71), an avoiding hole (11) allowing the fasteners (71) to pass through are provided on the support (10), an aperture of the avoiding hole (11) is greater than an outer diameter of each of the plurality of fastener (71), connecting holes (213) tightly connected to the plurality of fasteners (71) are provided on the frames (21), the LED display device further comprises a plurality of damping members (72), the plurality of damping members and the plurality of fasteners (71) are arranged in a one-to-one correspondence manner, and the damping members (72) are located between the avoiding holes (11) and heads of the fasteners (71), such that the fasteners (71) can swing up and down in the avoiding holes (11) when the frames (21) slide up and down.

11. The LED display device as claimed in claim 10, wherein the fasteners (71) comprise screw heads (711) and screw rods (712) connected with the screw heads (711), the connecting holes (213) are screw holes connected with the screw rods (712), the avoiding holes (11) comprise elongated hole sections (111) for avoiding the screw rods (712), and reamed hole sections (112) for accommodating the screw heads (711), an aperture of each of reamed hole sections (112) is greater than a maximum value of an aperture of each of the elongated hole sections (111), step surfaces are formed between the reamed hole sections (112) and the elongated hole sections (111), the damping members (72) comprise springs sleeving the screw rods (712), and the springs are located between the screw heads (711) and the step surfaces.

## Patentansprüche

1. Leuchtdioden-(LED)-Anzeigevorrichtung, umfassend:
einen Träger (10);
eine Vielzahl von Anzeigeanordnungen (20), die auf einer Vorderseite des Trägers (10) montiert sind, wobei die Vielzahl von Anzeigeanordnungen (20) in einer Reihe auf dem Träger (10) angeordnet ist, jede der Vielzahl von Anzeigeanordnungen (20) in einer Auf-Ab-Richtung verschiebbar angeordnet ist und jede der Vielzahl von Anzeigeanordnungen (20) einen Rahmen (21) und einen LED-Anzeigebildschirm (22) umfasst, der abnehmbar auf einer Vorderseite des Rahmens (21) angeordnet ist;
**dadurch gekennzeichnet, dass** die LED-Anzeigevorrichtung ferner eine Vielzahl von Gassäcken (30) umfasst, wobei jeder der Vielzahl von Gassäcken (30) zwischen den Rahmen (21) von zwei Anzeigeanordnungen (20) angeordnet ist, die in der Auf-Ab-Richtung nebeneinander angeordnet sind, und jeder der Vielzahl von Gassäcken (30) einen ausgedehnten Zustand und einen flachen Zustand aufweist,
wenn sich der Gassack (30) im flachen Zustand befindet, zwei benachbarte Anzeigeanordnungen (20), die sich oberhalb und unterhalb eines der mehreren Gassäcke (30) befinden, in berührender Weise miteinander zusammenwirken, und wenn der eine der mehreren Gassäcke (30) vom flachen Zustand in den ausgedehnten Zustand überführt wird, der Rahmen (21) oberhalb des einen der mehreren Gassäcke (30) nach oben verschiebbar angetrieben werden kann, so dass zwischen den beiden benachbarten Anzeigeanordnungen (20), die sich oberhalb und unterhalb des einen der mehreren Gassäcke (30) befinden, ein Ablösespalt gebildet wird.

2. LED-Anzeigevorrichtung nach Anspruch 1, wobei jeder der mehreren Gassäcke (30) einen flachen Gassackkörper (31) und eine am Gassackkörper (31) angeordnete Gasdüse (32) umfasst, wobei an den Rahmen (21) der beiden darüber und darunter angeordneten benachbarten Anzeigeanordnungen (20) erste Aufnahmeaussparungen (211) zur Aufnahme des Gassackkörpers (31) vorgesehen sind, und wobei die Gasdüse (32) durch die Rahmen (21) der beiden benachbarten Anzeigeanordnungen (20) verläuft.

3. LED-Anzeigevorrichtung nach Anspruch 1, ferner umfassend eine Gasquellenvorrichtung (40) zum Versorgen der Vielzahl von Gassäcken (30) mit Gas, wobei die Gasquellenvorrichtung (40) eine Gaspumpe (41) und/oder einen Gasgenerator (42) umfasst, wobei die Gasquellenvorrichtung (40) außerdem eine Vielzahl von ersten Gaskanälen (431) umfasst, die mit der Gaspumpe (41) und/oder dem Gasgenerator (42) in Verbindung stehen, wobei die Vielzahl von ersten Gaskanälen (431) parallel geschaltet ist, wobei die Vielzahl von ersten Gaskanälen (431) in einer Eins-zu-eins-Entsprechung mit der Vielzahl von Gassäcken (30) in Verbindung steht, und wobei an jedem der Vielzahl von ersten Gaskanälen (431) ein erstes Absperrventil (44) angeordnet ist.

4. LED-Anzeigevorrichtung gemäß Anspruch 3, wobei die Gasquellenvorrichtung (40) ferner einen Überlaufgaskanal umfasst, der mit einem beliebigen der Vielzahl der ersten Gaskanäle (431) in Verbindung steht, und wobei ein Überlaufventil (45) an dem Überlaufgaskanal angeordnet ist.

5. LED-Anzeigevorrichtung nach Anspruch 3, wobei die Gasquellenvorrichtung (40) die Gaspumpe (41) und den Gasgenerator (42) umfasst, die Gaspumpe (41) und der Gasgenerator (42) parallel geschaltet sind, die Vielzahl von ersten Gaskanälen (431) an einer Verbindungsstelle zusammenlaufen, die Verbindungsstelle über einen zweiten Gaskanal (432) mit der Gaspumpe (41) in Verbindung steht, ein erstes Einwegventil (46) an dem zweiten Gaskanal (432) angeordnet ist, ein dritter Gaskanal (433) zwischen einem Einlass des ersten Einwegventils (46) und dem Gasgenerator (42) angeordnet ist, ein zweites Einwegventil (47) an dem dritten Gaskanal (433) angeordnet ist, ein vierter Gaskanal (434) zwischen der Verbindungsstelle und einem Auslass des ersten Einwegventils (46) angeordnet ist, und ein zweites Absperrventil (48) an dem vierten Gaskanal (434) angeordnet ist.

6. LED-Anzeigevorrichtung nach Anspruch 1, ferner umfassend eine Vielzahl von in Abständen angeordneten vertikalen Stäben (51) und eine Vielzahl von in Abständen angeordneten horizontalen Stäben (52), wobei jeder der Vielzahl von vertikalen Stäben (51) und jeder der Vielzahl von horizontalen Stäben (52) versetzt angeordnet sind, jeweils zwei benachbarte vertikale Stäbe (51) der Vielzahl von vertikalen Stäben (51) durch einen Rahmen (21) verlaufen, jeweils zwei benachbarte horizontale Stäbe (52) durch einen Rahmen (21) verlaufen und zwischen einem Durchgangsloch jedes Rahmens (21), durch das die horizontalen Stäbe (52) verlaufen, und einem entsprechenden horizontalen Stab (52) der Vielzahl von horizontalen Stäben (52) ein Bewegungsspalt in der Auf-Ab-Richtung vorgesehen ist.

7. LED-Anzeigevorrichtung nach Anspruch 1, wobei an einer Seite eines Rahmens (21) von zwei links und rechts angeordneten benachbarten Rahmen (21) eine Rutsche (61) vorgesehen ist und an einer Seite des anderen Rahmens (21) von zwei links und rechts angeordneten benachbarten Rahmen (21) ein Gleitblock (62) angeordnet ist, der in eingeschobener Weise zu der Rutsche (61) passt.

8. LED-Anzeigevorrichtung nach Anspruch 1, wobei auf der Rückseite jedes Rahmens (21) eine zweite Aufnahmevertiefung (212) zur Aufnahme einer Kugel (63) vorgesehen ist und ein aus einer Öffnung der zweiten Aufnahmevertiefung (212) herausragender Teil der Kugel (63) in Kontakt mit einer Oberfläche des Trägers (10) zusammenwirkt.

9. LED-Anzeigevorrichtung nach Anspruch 8, wobei auf dem Rahmen (21) ein Paar Begrenzungselemente (64) angeordnet ist, die sich auf einer Oberseite und einer Unterseite der Kugel (63) befinden, und die Begrenzungselemente (64) abnehmbar in der zweiten Aufnahmevertiefung (212) angeordnet sind.

10. LED-Anzeigevorrichtung nach Anspruch 1, die ferner eine Vielzahl von Befestigungselementen (71) umfasst, die durch die Halterung (10) hindurchragen, wobei ein entsprechender Rahmen (21) durch jedes der Vielzahl von Befestigungselementen (71) einstellbar an der Halterung (10) montiert ist, wobei ein Vermeidungsloch (11), durch das die Befestigungselemente (71) hindurchgehen können, an der Halterung (10) vorgesehen ist, wobei eine Öffnung des Vermeidungslochs (11) größer ist als ein Außendurchmesser jedes der Vielzahl von Befestigungselementen (71), wobei Verbindungslöcher (213), die fest mit der Vielzahl von Befestigungselementen (71) verbunden sind, an den Rahmen (21) vorgesehen sind, wobei die LED-Anzeigevorrichtung ferner eine Vielzahl von Dämpfungselementen (72) umfasst, wobei die Vielzahl von Dämpfungselementen und die Vielzahl von Befestigungselementen (71) in einer Eins-zu-eins-Entsprechung angeordnet sind und wobei die Dämpfungselemente (72) zwischen den Vermeidungslöchern (11) und den Köpfen der Befestigungselemente (71) angeordnet sind, so dass die Befestigungselemente (71) in den Vermeidungslöchern (11) auf und ab schwingen können, wenn die Rahmen (21) auf und ab gleiten.

11. LED-Anzeigevorrichtung nach Anspruch 10, wobei die Befestigungselemente (71) Schraubenköpfe (711) und mit den Schraubenköpfen (711) verbundene Schraubenstangen (712) umfassen, die Verbindungslöcher (213) mit den Schraubenstangen (712) verbundene Schraubenlöcher sind, die Vermeidungslöcher (11) Langlochabschnitte (111) zum Vermeiden der Schraubenstangen (712) und Passlochabschnitte (112) zum Aufnehmen der Schraubenköpfe (711) umfassen, eine Öffnung jedes Passlochabschnitts (112) größer ist als ein Maximalwert einer Öffnung jedes Langlochabschnitts (111), Stufenflächen zwischen den Passlochabschnitten (112) und den Langlochabschnitten (111) gebildet sind, die Dämpfungselemente (72) Federn umfassen, die die Schraubenstangen (712) umhüllen, und die Federn zwischen den Schraubenköpfen (711) und den Stufenflächen angeordnet sind.

## Revendications

1. Dispositif d'affichage à diodes électroluminescentes (DEL), comprenant :
un support (10) ;
une pluralité d'ensembles d'affichage (20) montés sur un côté avant du support (10), la pluralité d'ensembles d'affichage (20) étant agencée en un réseau sur le support (10), chacun de la pluralité d'ensembles d'affichage (20) étant agencé de manière coulissante dans une direction supérieure-inférieure, et chacun de la pluralité d'ensembles d'affichage (20) comprenant un cadre (21) et un écran d'affichage à DEL (22) agencé de manière amovible sur un côté avant du cadre (21) ;
**caractérisé en ce que** le dispositif d'affichage à DEL comprend en outre une pluralité de sacs à gaz (30), chacun de la pluralité de sacs à gaz (30) étant agencé entre les cadres (21) de deux ensembles d'affichage (20) adjacents l'un à l'autre dans la direction supérieure-inférieure, chacun de la pluralité de sacs à gaz (30) ayant un état déployé et un état plat,
lorsque le sac à gaz (30) est à l'état plat, deux ensembles d'affichage adjacents (20) situés au-dessus et au-dessous de l'un de la pluralité de sacs à gaz (30) coopèrent l'un avec l'autre par contact, et lorsque l'un de la pluralité de sacs à gaz (30) passe de l'état plat à l'état déployé, le cadre (21) au-dessus de l'un de la pluralité de sacs à gaz (30) peut être entraîné à coulisser vers le haut, de sorte qu'un espace de détachement soit formé entre les deux ensembles d'affichage adjacents (20) situés au-dessus et au-dessous de l'un de la pluralité de sacs à gaz (30).

2. Dispositif d'affichage à DEL selon la revendication 1, dans lequel chacun de la pluralité de sacs à gaz (30) comprend un corps de sac à gaz plat (31) et une buse à gaz (32) agencée sur le corps de sac à gaz (31), des premiers évidements de logement (211) pour loger le corps de sac à gaz (31) sont prévus sur les cadres (21) des deux ensembles d'affichage adjacents (20) situés au-dessus et au-dessous, et la buse à gaz (32) traverse les cadres (21) des deux ensembles d'affichage adjacents (20).

3. Dispositif d'affichage à DEL selon la revendication 1, comprenant en outre un dispositif source de gaz (40) pour alimenter en gaz la pluralité de sacs à gaz (30), le dispositif source de gaz (40) comprend une pompe à gaz (41) et/ou un gonfleur (42), le dispositif source de gaz (40) comprend en outre une pluralité de premiers canaux de gaz (431) en communication avec la pompe à gaz (41) et/ou le gonfleur (42), la pluralité de premiers canaux de gaz (431) est connectée en parallèle, la pluralité de premiers canaux de gaz (431) est en communication avec la pluralité de sacs à gaz (30) selon une correspondance biunivoque, et une première vanne à guillotine (44) est agencée sur chacun de la pluralité des premiers canaux de gaz (431).

4. Dispositif d'affichage à DEL selon la revendication 3, dans lequel le dispositif de source de gaz (40) comprend en outre un canal de gaz de trop-plein en communication avec l'un quelconque d'une pluralité des premiers canaux de gaz (431), et une soupape de trop-plein (45) est agencée sur le canal de gaz de trop-plein.

5. Dispositif d'affichage à DEL selon la revendication 3, dans lequel le dispositif de source de gaz (40) comprend la pompe à gaz (41) et le gonfleur (42), la pompe à gaz (41) et le gonfleur (42) sont connectés en parallèle, la pluralité de premiers canaux de gaz (431) converge au niveau d'une jonction, la jonction est en communication avec la pompe à gaz (41) par un deuxième canal de gaz (432), une première valve unidirectionnelle (46) est agencée sur le deuxième canal de gaz (432), un troisième canal de gaz (433) est agencé entre une entrée de la première valve unidirectionnelle (46) et le gonfleur (42), une seconde valve unidirectionnelle (47) est agencée sur le troisième canal de gaz (433), un quatrième canal de gaz (434) est agencé entre la jonction et une sortie de la première valve unidirectionnelle (46), et une seconde vanne à guillotine (48) est agencée sur le quatrième canal de gaz (434).

6. Dispositif d'affichage à DEL selon la revendication 1, comprenant en outre une pluralité de tiges verticales (51) agencées à des intervalles réguliers et une pluralité de tiges horizontales (52) agencées à des intervalles réguliers, chacune de la pluralité des tiges verticales (51) et chacune de la pluralité des tiges horizontales (52) étant agencées de manière décalée, toutes les deux tiges verticales adjacentes (51) de la pluralité des tiges verticales (51) traversent un cadre (21), toutes les deux tiges horizontales adjacentes (52) traversent un cadre (21), et un espace de mouvement dans la direction supérieure-inférieure est prévu entre un trou traversant de chaque cadre (21) permettant le passage des tiges horizontales (52) et une tige horizontale correspondante (52) de la pluralité de tiges horizontales (52).

7. Dispositif d'affichage à DEL selon la revendication 1, dans lequel une goulotte (61) est prévue sur un côté d'un cadre (21) de deux cadres adjacents (21) situés à gauche et à droite, et un bloc coulissant (62) correspondant à la goulotte (61) de manière insérée est agencé sur un côté de l'autre cadre (21) parmi deux cadres adjacents (21) situés à gauche et à droite.

8. Dispositif d'affichage à DEL selon la revendication 1, dans lequel un second évidement de logement (212) destiné à loger une bille (63) est prévu sur un côté arrière de chaque cadre (21), et une partie de la bille (63) dépassant d'une ouverture du second évidement de logement (212) coopère avec une surface du support (10) par contact.

9. Dispositif d'affichage à DEL selon la revendication 8, dans lequel une paire d'éléments de limitation (64) situés sur un côté supérieur et un côté inférieur de la bille (63) est agencée sur le cadre (21), et les éléments de limitation (64) sont situés de manière amovible dans le second évidement de logement (212).

10. Dispositif d'affichage à DEL selon la revendication 1, comprenant en outre une pluralité d'éléments de fixation (71) pénétrant à travers le support (10), un cadre correspondant (21) est monté de manière réglable sur le support (10) par chacun de la pluralité d'éléments de fixation (71), un trou d'évitement (11) permettant le passage des éléments de fixation (71) est prévu sur le support (10), une ouverture du trou d'évitement (11) est supérieure à un diamètre extérieur de chacun de la pluralité d'éléments de fixation (71), des trous de connexion (213) étroitement connectés à la pluralité d'éléments de fixation (71) sont prévus sur les cadres (21), le dispositif d'affichage à DEL comprend en outre une pluralité d'éléments d'amortissement (72), la pluralité d'éléments d'amortissement et la pluralité d'éléments de fixation (71) sont agencées de manière à correspondre de manière biunivoque, et les éléments d'amortissement (72) sont situés entre les trous d'évitement (11) et les têtes des éléments de fixation (71), de sorte que les éléments de fixation (71) peuvent basculer vers le haut et vers le bas dans les trous d'évitement (11) lorsque les cadres (21) coulissent de haut en bas.

11. Dispositif d'affichage à DEL selon la revendication 10, dans lequel les éléments de fixation (71) comprennent des têtes de vis (711) et des tiges de vis (712) connectées aux têtes de vis (711), les trous de connexion (213) sont des trous de vis connectés aux tiges de vis (712), les trous d'évitement (11) comprennent des sections de trou allongé (111) pour éviter les tiges de vis (712), et des sections de trou alésé (112) pour loger les têtes de vis (711), une ouverture de chacune des sections de trou alésées (112) est supérieure à une valeur maximale d'une ouverture de chacune des sections de trou allongé (111), des surfaces étagées sont formées entre les sections de trou alésé (112) et les sections de trou allongé (111), les éléments d'amortissement (72) comprennent des ressorts gainant les tiges de vis (712), et les ressorts sont situés entre les têtes de vis (711) et les surfaces étagées.
